# EUROPÄISCHE PATENTSCHRIFT

(11) **EP 3 763 006 B1**
(45) Veröffentlichungstag und Bekanntmachung des Hinweises auf die Patenterteilung: **02.11.2022**
(21) Anmeldenummer: 19708490.8
(22) Anmeldetag: 28.02.2019
(51) Int. Cl.: H01S 5/183, H01S 5/06, H01S 5/042, H01S 5/187

(54) **VORRICHTUNG ZUR INJEKTION SPINPOLARISIERTER LADUNGSTRÄGER UND ZUR REFLEXION VON LICHT**
DEVICE FOR INJECTING SPIN POLARISED CHARGE CARRIERS AND FOR REFLECTING LIGHT
DISPOSITIF POUR L' INJECTION DE PORTEURS DE CHARGE ET POUR LA REFLEXION DE LUMIERE

(30) Priorität: 08.03.2018 DE 102018105345
(43) Veröffentlichungstag der Anmeldung: 13.01.2021
(73) Patentinhaber: Ruhr-Universität Bochum, 44801 Bochum (DE)
(72) Erfinder: LINDEMANN, Markus, 45473 Mülheim an der Ruhr (DE); GERHARDT, Nils, 44799 Bochum (DE); HOFMANN, Martin, 45527 Hattingen (DE)
(74) Vertreter: Taruttis, Tilman
(86) Internationale Anmeldenummer: PCT/EP2019/055009
(87) Internationale Veröffentlichungsnummer: WO 2019/170517

(56) Entgegenhaltungen:
- EP-A1- 1 503 328
- WO-A1-2007/045114
- DE-A1- 10 243 944
- US-A1- 2003 075 767
- US-A1- 2006 186 432

## Beschreibung

Die Erfindung betrifft eine Vorrichtung zur Injektion spinpolarisierter Ladungsträger und zur Reflexion von Licht in einen Laser oder eine resonante LED. Die Vorrichtung kann insbesondere ein Spin-Injektor für eine oberflächenemittierende Laserdiode sein. Die Erfindung betrifft weiterhin eine Anordnung mit einer solchen Vorrichtung sowie ein Verfahren zu dessen Betrieb. Bei der Anordnung handelt es sich um ein lichtemittierendes Bauelement mit einem Resonator wie einen Laser oder eine resonante LED. Die Anordnung wird als sogenanntes "Device mit Cavity" bezeichnet werden. Die immer weiter fortschreitende weltweite Vernetzung durch das Internet erfordert immer höhere Datenübertragungsraten. Ein erheblicher Anteil des zu übertragenden Datenvolumens findet dabei zwischen Servern innerhalb eines Rechenzentrums statt, sodass ein erheblicher Anteil des Datenvolumens nur über eine vergleichsweise kurze Strecke übertragen werden muss. Insbesondere können bei derartigen Anwendungen Daten günstigerweise optisch übertragen werden. Die zur optischen Datenübertragung auf kurzen Strecken, beispielsweise zwischen den Servern innerhalb eines Rechenzentrums, verwendeten Laser sollen preisgünstig, klein und dennoch schnell modulierbar sein. In konventionellen Systemen werden hierfür intensitätsmodulierte Laser verwendet.

Alternativ zur Modulation der Intensität eines Lasers kann die Polarisation des Laserlichts moduliert werden, d.h. so verändert werden, dass die Veränderungen der Polarisation die zu übertragende Information wiedergeben. Dabei ist es hinsichtlich der Baugröße und Modulationsgeschwindigkeit vorteilhaft, wenn der Modulator in den sendenden Laser integriert ist.

Die Polarisation des Laserlichts kann durch die Spinorientierung der Ladungsträger in einem Halbleiterlaser gesteuert werden. Dabei kann die Polarisationsmodulation schneller als eine Intensitätsmodulation durchgeführt werden, weil die durch Material- und Geometrieparameter bestimmte und dem Polarisationsmodulationssystem zugeordnete Resonanzfrequenz höher sein kann als die eines Intensitätsmodulationssystems. Dies kann insbesondere durch eine Maximierung der Doppelbrechung des Lasermaterials erreicht werden.

Laser, welche die Spineigenschaft der Ladungsträger zur Steuerung der Polarisation des Laserlichts nutzen, werden hier als sogenannte Spin-Laser bezeichnet. Sogenannte vertical-cavity surface-emitting laser, in der Literatur kurz VCSEL genannt, welche die Spin-Eigenschaft von Ladungsträgern nutzen, werden als Spin-vertical-cavity surface-emitting laser bezeichnet, kurz Spin-VCSEL, und im Deutschen Spin-polarisierter oberflächenemittierender Laser.

Die Publikation "Spintronics stretches its arms to lasers" von Jeongsu Lee und Igor Zutic, veröffentlicht in 2012, beschreibt einen Spin-VCSEL, wobei der Laser einen herkömmlichen Aufbau mit einem aktiven Gebiet aufweist, welches zwischen zwei einander gegenüberliegenden Bragg-Spiegeln, in der Fachliteratur auch Distributed Bragg Reflector (DBR) genannt, angeordnet ist. Die einander gegenüberliegenden DBRs bilden dabei einen Laser-Resonator. Bei dieser Anordnung werden spinpolarisierte Elektronen durch eine Abstandsschicht (Spacer), welche das aktive Gebiet von einem DBR trennt, in das aktive Gebiet eingebracht. Der Spin-Zustand der spinpolarisierten Ladungsträger wird dabei entweder durch die Magnetisierung eines geeigneten magnetischen Spin-Injektionskontaktes oder durch Ausrichtung in magnetischen Transportschichten vorgegeben. Weiterhin ist die Ausrichtung durch ein externes magnetisches Feld möglich. Ein geeigneter Spin-Injektionskontakt basiert typischerweise auf einer ferro- oder paramagnetischen Metallschicht von der aus spinpolarisierte Ladungsträger durch Tunnelprozesse in die nichtmagnetischen Halbleiterschichten des Lasers injiziert werden. Rekombiniert ein spinpolarisiertes Elektron mit einem depolarisierten Loch, so bestimmt die Spinpolarisation des Elektrons die zirkulare Polarisation des entstehenden Lichtfeldes. Auf diese Weise kann die Richtung der zirkularen Polarisation der erzeugten Photonen, also die Emissionspolarisation, durch die Polarisationsrichtung des Spins der in das aktive Gebiet eingebrachten Elektronen festgelegt werden. Es gibt auch Materialen, bei denen der Löcherspin langsam dephasiert. Insoweit ist die Verwendung von spinpolarisierten Elektronen und unpolarisierten Löchern beispielhaft zu verstehen. Als Ladungsträger kommen Elektronen und Löcher in Betracht. Ein ähnlicher herkömmlicher Aufbau ist aus der EP 1 503 328 A1 bekannt.

Spinpolarisierte Elektronen weisen die Eigenschaft auf, dass der Spin des Elektrons auf dem Weg in das aktive Gebiet des Laserresonators verloren geht, wenn der Weg dorthin zu lang ist, also der Transportweg des Elektrons in das aktive Gebiet länger ist als die sogenannte Spinrelaxationslänge. Die Spinrelaxationslänge hängt dabei auch von der Temperatur und einem potentiellen Magnetfeld im Bereich des Transportweges ab, wobei tiefe Temperaturen und ein entsprechend polarisiertes Magnetfeld die Spinrelaxationslänge verlängern. Herkömmliche Anwendungen, welche die Spinpolarisation von Elektronen nutzen, verwenden daher sehr tiefe Temperaturen von beispielsweise wenigen 10 mK und/oder starke Magnetfelder von mehreren Tesla, um die Spinrelaxationslänge zu verlängern, sodass die Spinpolarisation eines Elektrons auf dem Transportweg möglichst lange erhalten bleibt. Derart tiefe Temperaturen und derart starke Magnetfelder sind aber bei vielen praktischen Anwendungen nicht realisierbar.

Damit das bei der Rekombination eines Elektrons mit einem Loch entstehende Lichtfeld polarisiert ist, darf der Spin des spinpolarisierten Elektrons auf dem Transportweg bis zur Rekombination nicht verloren gehen. Daher sind kurze Transportwege für einen effizienten Betrieb bevorzugt.

### FIGURENBESCHREIBUNG

Nachfolgend wird die Erfindung näher anhand der Figuren erläutert. Dabei zeigen:
- Fig. 1:: eine schematische Querschnittsdarstellung eines ersten Ausführungsbeispiels eines Lasers mit einer Vorrichtung zur Injektion spinpolarisierter Elektronen und zur Reflexion von Licht,
- Fig. 2:: eine schematische Draufsicht auf den Laser aus Fig. 1, und
- Fig. 3:: eine schematische Querschnittsdarstellung eines zweiten Ausführungsbeispiels eines Lasers mit einer Vorrichtung zur Injektion spinpolarisierter Elektronen und zur Reflexion von Licht.

### BESCHREIBUNG

Die beschriebene Vorrichtung wird in einem Laser oder einer resonanten LED zur Injektion spinpolarisierter Ladungsträger wie Elektronen und Löcher und zur Reflexion von Licht genutzt. Im Folgenden wird beispielhaft von der Injektion spinpolarisierter Löchern ausgegangen.

Damit können spinpolarisierte Elektronen derart in den aktiven Bereich eines Lasers injiziert werden, dass die Elektronen über den gesamten aktiven Bereich homogen einen besonders kurzen Weg bis zur Rekombination mit Löchern, und damit bis zur Erzeugung von Licht, zurücklegen müssen. Somit kann der beschriebene Laser auch mit besonders kurzen Spinrelaxationslängen, und damit bei vergleichsweise hohen Temperaturen und/oder niedrigen externen Magnetfeldern, betrieben werden. Es ist sogar möglich, vollständig auf externe Magnetfelder zu verzichten.

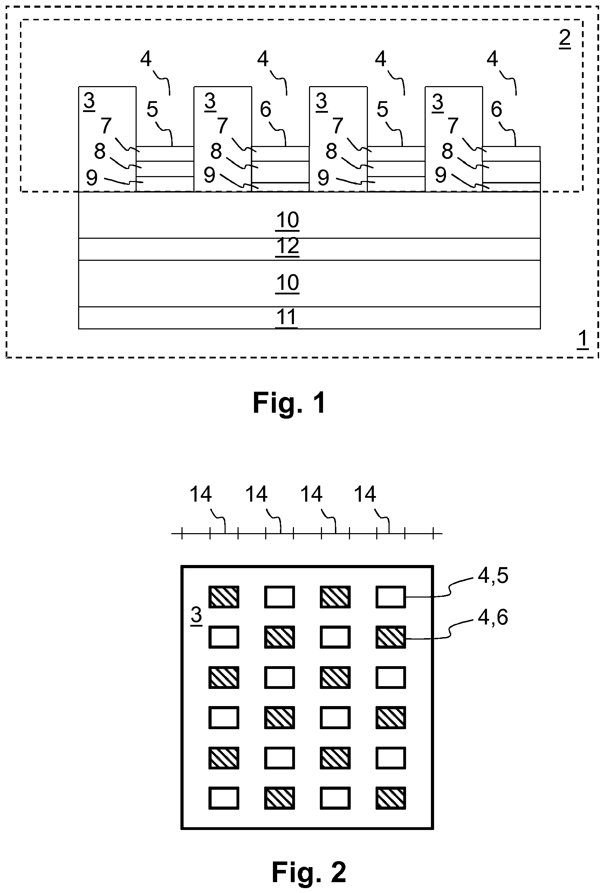

Fig. 1 zeigt eine schematische Querschnittsdarstellung einer ersten Ausführungsform eines Lasers 1 mit einer Vorrichtung 2 zur Injektion spinpolarisierter Elektronen und zur Reflexion von Licht. Der Laser 1 weist Halbleitermaterialien auf, so dass der Laser 1 auch als ein Halbleiterlaser und/oder als eine Laserdiode bezeichnet werden kann. Der in Fig. 1 gezeigte Laser 1 ist eine bevorzugte Ausführungsform einer Anordnung, die die beschriebene Vorrichtung umfasst. Bei der Anordnung kann es allgemein um ein lichtemittierendes Bauelement mit einem Resonator handeln. Neben einem Laser kann das auch beispielsweise eine resonante LED sein. Die Anordnung kann insbesondere als ein "Device mit Cavity" bezeichnet werden.

Mit dem Laser 1 kann Laserlicht erzeugt werden, indem Elektronen und Löcher in einem aktiven Bereich 12 des Lasers 1 rekombinieren. Bei der Rekombination entsteht durch freiwerdende Energie ein Photon. Der aktive Bereich 12 wird als ein p-n-Übergang ausgebildet.

Das Laserlicht entsteht dabei am Übergang zwischen einem p-dotierten Bereich und einem n-dotierten Bereich. Als Material für den aktiven Bereich 12 kommen beispielsweise p-GaAs und n-GaAs in Betracht. Durch die Wahl des Materials und/oder der Dotierung des Materials des aktiven Bereichs 12 kann die Wellenlänge des von dem Laser 1 erzeugten Laserlichts festgelegt werden.

Die in dem aktiven Bereich 12 erzeugten Photonen werden von einem unterhalb des aktiven Bereichs 12 angeordneten Spiegel 11 und der von oberhalb des aktiven Bereichs 12 angeordneten Vorrichtung 2, die der Reflexion von Licht dient, reflektiert. Diese Reflexion der erzeugten Photonen führt gemäß dem Laserprinzip zur induzierten Emission weiterer Photonen. Dadurch entsteht in dem aktiven Bereich 12 Laserlicht. Die Anordnung der Vorrichtung 2 oberhalb des aktiven Bereichs 12 und des Spiegels 11 unterhalb des aktiven Bereichs 12 ist beispielhaft. Die Anordnung 1 kann beliebig orientiert sein. So können insbesondere auch die Vorrichtung 2 unterhalb des aktiven Bereichs 12 und der Spiegel 11 oberhalb des aktiven Bereichs 12 angeordnet sein.

Der Spiegel 11 ist vorzugsweise als Bragg-Spiegel ausgebildet. So kommt insbesondere ein sogenannter Distributed Bragg Reflector (DBR) in Betracht. Der Bragg-Spiegel umfasst vorzugsweise eine Vielzahl von Schichten, die in ihrer Gesamtheit das erzeugte Licht reflektieren. Die Schichten sind vorzugsweise aus Halbleitermaterial gebildet. Dabei sind die Materialien vorzugsweise derart gewählt, dass sich Schichten mit einem ersten Brechungsindex und einem zweiten Brechungsindex abwechseln. So können beispielsweise Schichten aus GaAs und AlGaAs abwechselnd angeordnet sein. Die Schichtdicke ist vorzugsweise bei allen Schichten jeweils gleich einem Viertel der Wellenlänge des zu reflektierenden Lichts, so dass die Reflexion des Lichts nach Art der Bragg-Reflexion erfolgen kann. Alternativ kann der Spiegel auch als ein Metallspiegel ausgebildet sein. Die Vorrichtung 2 umfasst zumindest eine Gitterstruktur 3 mit einer Vielzahl von Ausnehmungen 4. Diese ist in dem hier beschriebenen Ausführungsbeispiel an dem aktiven Bereich 12 und gegenüber dem Spiegel 11 angeordnet, dass die Gitterstruktur Photonen, welche in dem aktiven Bereich erzeugt werden, wenigstens teilweise in das aktive Gebiet zurückspiegelt. In Zusammenspiel mit dem gegenüberliegenden Spiegel, also dem Spiegel 11, bildet die Gitterstruktur damit einen Laserresonator. In Fig. 1 sind vier Ausnehmungen 4 gezeigt, die zwischen Teilen der Gitterstruktur 3 ausgebildet sind. Die Gitterstruktur 3 ist vorzugsweise mit einem Halbleitermaterial gebildet.

Wie an der in Fig. 2 gezeigten Draufsicht auf den Laser 1 aus Fig. 1 zu erkennen, ist die Gitterstruktur 3 in einer Ausführungsform rechteckig ausgebildet. Das bedeutet, dass die Ausnehmungen 4 rechteckig ausgebildet und entlang gerader, senkrecht zueinander stehender oder paralleler Linien angeordnet und ausgerichtet sind. Die Ausnehmungen 4 haben vorzugsweise alle die gleiche Form und/oder Ausdehnung. Die Abstände zwischen benachbarten Ausnehmungen sind vorzugsweise alle gleich groß.

Je kleiner die Ausnehmungen 4 sind, umso besser kann das Licht an der Gitterstruktur 3 reflektiert werden. Es ist bevorzugt, dass die Länge 14 der Ausnehmungen 4 in der Gitterstruktur 3 kleiner als die Wellenlänge des zu reflektierenden Lichts und insbesondere kleiner als die halbe Wellenlänge des zu reflektierenden Lichts ist. Unter der Länge 14 der Ausnehmungen 4 ist die größte Ausdehnung der Ausnehmungen 4 innerhalb einer Ebene quer zur Gitterstruktur 3 zu verstehen. Das ist die in Fig. 2 gezeigte Ebene. Bei derart kleinen Ausnehmungen 4 in der Gitterstruktur 3 kann das Licht besonders gut reflektiert werden.

Die Gitterstruktur kann auch anders als in den Figuren dargestellt ausgebildet sein. So kommt insbesondere in Betracht, dass die Gitterstruktur nur eindimensional ausgebildet ist. Das bedeutet, dass die Ausnehmungen in nur einer Richtung entlang paralleler Linien angeordnet sind, während in einer Richtung quer zu dieser Richtung keine Ausnehmungen vorgesehen sind. Eine derartige Ausgestaltung kann auch damit beschrieben werden, dass die Anzahl der Gitterperioden in einer Richtung Eins ist. Es ist auch möglich, dass die Gitterstruktur nicht rechtwinklig, sondern in ringförmigen Strukturen ausgebildet ist.

Der aktive Bereich 12, der Spiegel 11 und die Vorrichtung 2 sind vorzugsweise als Festkörper mit einer jeweiligen Kristallgitterstruktur ausgebildet. Die Kristallgitterstruktur ist von der hier beschriebenen Gitterstruktur 3 zu unterscheiden. Die Gitterstrukturen des aktiven Bereichs 12, des Spiegels 11 und der Vorrichtung 2 können unterschiedlich sein. Insbesondere, um Verspannungen durch ein derartiges Gitter-Mismatch zu vermeiden, kann - wie im Beispiel der Fig. 1 gezeigt - eine jeweilige Ausgleichsschicht 10 zwischen dem aktiven Bereich 12 und dem Spiegel 11 und/oder zwischen dem aktiven Bereich 12 und der Vorrichtung 2 vorgesehen sein. Die Ausgleichsschichten 10 sind vorzugsweise aus Halbleitermaterial gebildet. Die Ausgleichsschichten 10 können insbesondere auch als "phasematching layer" bezeichnet werden. Sofern die Injektion von Elektronen in den aktiven Bereich beschrieben wird, ist damit auch die Injektion von Elektronen durch die Ausgleichsschicht 10 in den aktiven Bereich 12 gemeint, wenn eine Ausgleichsschicht 10 vorhanden ist. In dem aktiven Bereich 12 erzeugte Photonen durchlaufen vor der Reflexion an dem Spiegel 11 die Ausgleichsschicht 10, werden dann an dem Spiegel 11 reflektiert, durchlaufen wieder die Ausgleichsschicht 10, sodass die Photonen zurück in den aktiven Bereich 12 gelangen.

Die Ausgleichsschicht 10 bildet zusammen mit dem aktiven Bereich 12 den Resonator des Lasers und besitzt insgesamt eine optische Dicke n^{∗}d, die vorzugsweise etwa der Emissionswellenlänge entspricht. Auch ist die Lage des aktiven Bereichs 12 nicht zwingend in der Mitte des Resonators.

Die Ausgleichsschichten 10 müssen nicht klar von dem aktiven Bereich 12, von der Vorrichtung 2 und/oder von dem Spiegel 11 getrennt sein. Es ist auch möglich, dass ein fließender Übergang zwischen einer Ausgleichsschicht 10 und der Vorrichtung 2, dem aktiven Bereich 12 und/oder dem Spiegel 11 vorliegt. Ist keine Ausgleichsschicht 10 vorgesehen, kann auch der aktive Bereich 12 fließend in die Vorrichtung 2 und/oder in den Spiegel 11 übergehen. So kann beispielsweise auch der Spiegel 11 eine Dotierung aufweisen, die zur Erzeugung des Laserlichts beiträgt.

Alternativ ist es bevorzugt, dass die Ausgleichsschichten 10 klar von dem aktiven Bereich 12, von der Vorrichtung 2 und/oder von dem Spiegel 11 getrennt sind. Sind keine Ausgleichsschichten 10 vorgesehen, ist bevorzugt, dass der aktive Bereich 12 klar von der Vorrichtung 2 und/oder von dem Spiegel 11 getrennt ist. Die Vorrichtung 2 ist weiterhin dazu bestimmt und eingerichtet, Elektronen in den aktiven Bereich 12 zu injizieren. Die Elektronen sind dabei spin-polarisiert. Das bedeutet, dass die Spinorientierung der injizierten Elektronen nicht gleichmäßig auf die beiden möglichen Spinzustände "Up" und "Down" verteilt ist, sondern dass einer der Spinzustände überwiegt. Die Gesamtheit der injizierten Elektronen ist somit in diesem Spinzustand spinpolarisiert. Bei dem beschriebenen Laser 1 kann die Spinpolarisation des Ladungsträgersystems, also der Elektronen, genutzt werden, um die Polarisation des erzeugten Lichts und damit eine Lichteigenschaft zu beeinflussen. Die Polarisation des Lichts kann insbesondere durch Auf- und Abbau der Spinpolarisation beeinflusst werden. Dazu kann beispielsweise zwischen Up- und Down-Spin oder zwischen spinpolarisiertem und unpolarisierten Fall umgeschaltet werden. Die spinpolarisierten Elektronen werden durch Injektionskontakte 5, 6 und gegebenenfalls über die Ausgleichsschicht 10 in den aktiven Bereich 12 injiziert.

Zumindest in einem Teil der Ausnehmungen 4 der Gitterstruktur 3 ist dazu ein jeweiliger Injektionskontakt 5, 6 angeordnet. Vorzugsweise ist - wie im Beispiel der Fig. 1 gezeigt - in jeder der Ausnehmungen 4 ein jeweiliger Injektionskontakt 5, 6 angeordnet.

Die Injektionskontakte 5, 6 weisen - wie im Beispiel der Fig. 1 gezeigt - eine jeweilige metallische Schicht 7 auf. Die metallische Schicht 7 kann beispielsweise mit Gold, Chrom und/oder Aluminium gebildet sein. Über die metallischen Schichten 7 werden die Injektionskontakte 5, 6 beispielsweise über entsprechende Zuleitungen kontaktiert. Es können dabei alle Injektionskontakte 5, 6 gemeinsam kontaktiert werden. Alternativ können einzelne Injektionskontakte 5, 6 oder Gruppen von Injektionskontakten 5, 6 individuell kontaktiert werden. Die metallische Schicht 7 kann auch dazu dienen, darunterliegende Schichten zu schützten. Insoweit kann die metallische Schicht 7 auch als ein "cap layer" bezeichnet werden.

Jeder der Injektionskontakte 5, 6 umfasst eine jeweilige ferromagnetische Schicht 8. Als ferromagnetische Schicht 8 kann ein Schichtaufbau aus mehreren Unterschichten verwendet werden. Ein derartiger Schichtaufbau soll hier als eine ferromagnetische Schicht 8 aufgefasst werden. Beispielsweise kann die ferromagnetische Schicht 8 als eine Multilayer-Folge aus Fe/Tb, Fe/Pt, Co/Pt und/oder Co/Ni oder als Legierung beispielsweise mit FeTb und/oder CoFeB ausgeführt sein. Die ferromagnetische Schicht 8 kann beispielsweise mit Eisen und/oder Terbium gebildet sein.

Durch die ferromagnetische Schicht 8 können Elektronen polarisiert werden. Werden nicht-spinpolarisierte Elektronen in die ferromagnetische Schicht 8 eingeleitet, kann die Magnetisierung der ferromagnetischen Schicht 8 Elektronen der einen Spinorientierung bevorzugt passieren lassen und die Elektronen der anderen Spinorientierung zurückhalten. In einem vereinfachten Modell kann dies damit beschrieben werden, dass eine ferromagnetische Schicht 8 für die Elektronen der beiden Spinorientierungen unterschiedliche ohmsche Widerstände aufweist.

Es ist bevorzugt, dass die ferromagnetische Schicht 8 eine Magnetisierung aufweist, die senkrecht zu der ferromagnetischen Schicht 8 orientiert ist. Eine derartige Magnetisierung kann auch als "out-of-plane"-Magnetisierung bezeichnet werden. Insbesondere bei Multischichtsystemen oder Mischsystemen aus Metallen der seltenen Erden und Übergangsmetallen kann eine derart orientierte Magnetisierung besonders leicht eingestellt werden. Eine "out-of-plane"-Magnetisierung kann sich bei einer, insbesondere hinsichtlich der Schichtdicke, entsprechend dimensionierten Schicht spontan einstellen. Somit kann auf ein dauerhaft anliegendes externes Magnetfeld verzichtet werden, was die praktische Verwendbarkeit des Lasers 1 verbessert.

Weiterhin ist es bevorzugt, dass zumindest ein Teil der Injektionskontakte 5, 6 eine jeweilige Tunnelbarriere 9 umfasst. Vorzugsweise umfassen alle Injektionskontakte 5, 6 eine jeweilige Tunnelbarriere 9. Die Tunnelbarriere 9 kann insbesondere aus einem Oxid - wie beispielsweise MgO oder Al₂O₃ - ausgebildet sein. Bei der Spin-Injektion aus der ferromagnetischen Schicht 8 in den aktiven Bereich 12 des Lasers 1 kann es zu einem erheblichen Verlust der Spinpolarisation, insbesondere an der Grenzfläche zwischen der ferromagnetischen Schicht 8 und einem daran angrenzenden Halbleitermaterial, kommen. Das Halbleitermaterial kann insbesondere Teil des aktiven Bereichs 12 oder der Ausgleichsschicht 10 sein. Ein derartiger Verlust der Spinpolarisation kann insbesondere durch einen großen Unterschied zwischen der elektrischen Leitfähigkeit von ferromagnetischem Material und Halbleitermaterial begründet sein. Durch eine Tunnelbarriere 9 kann ein derartiger Verlust der Spinpolarisation reduziert oder ganz vermieden werden.

Alternativ oder zusätzlich zu einer Tunnelbarriere 9 können auch die intrinsischen Eigenschaften der verwendeten Materialien zur Bildung einer Barriere ausgenutzt werden. So ist es bevorzugt, dass zumindest ein Teil der Injektionskontakte 5, 6 der Vorrichtung 2 als ein jeweiliger Schottky-Kontakt ausgebildet ist. Die Ausbildung der Injektionskontakte 5, 6 als Schottky-Kontakte kann dabei von den Materialeigenschaften des angrenzenden Halbleitermaterials, beispielsweise der Ausgleichsschicht 10 oder des aktiven Bereichs 12, insbesondere von dessen Bandstruktur abhängen. Insoweit sind die Schottky-Kontakte bei der beschriebenen Vorrichtung 2 bei Verwendung der Vorrichtung 2 für einen bestimmten Laser 1 ausgebildet.

Vorzugsweise sind alle Injektionskontakte 5, 6 als Schottky-Kontakte ausgebildet. Alternativ ist es bevorzugt, dass alle Injektionskontakte 5, 6 eine jeweilige Tunnelbarriere 9 aufweisen. Es ist aber auch möglich, dass nur ein Teil der Injektionskontakte 5, 6 eine Tunnelbarriere 9 aufweist, dass ein anderer Teil der Injektionskontakte 5, 6 jeweils als Schottky-Kontakt ausgebildet ist und/oder dass ein wiederum anderer Teil der Injektionskontakte 5, 6 keine Barriere aufweist. Durch die Injektionskontakte 5, 6 können spinpolarisierte Elektronen in den aktiven Bereich 12 des Lasers 1 injiziert werden. Löcher können beispielsweise über einen oder mehrere Gegenkontakte in den aktiven Bereich 12 injiziert werden. In den Figuren ist der Gegenkontakt nicht eingezeichnet. Als Gegenkontakt kommt insbesondere eine Metallelektrode in Betracht.

Durch die Injektion der spinpolarisierten Elektronen in den aktiven Bereich 12 kann dort polarisiertes Licht erzeugt werden. Der Weg zwischen den Injektionskontakten 5, 6 und dem aktiven Bereich 12 ist bei dem beschriebenen Laser 1 besonders klein, weil die Elektronen durch einen der Reflektoren des Lasers 1 und damit sehr nah am aktiven Bereich 12 injiziert werden. In der hier beschriebenen Ausführungsform müssen die spinpolarisierten Elektronen dann nur noch die Dicke der Ausgleichsschicht durchlaufen um in den aktiven Bereich 12 zu gelangen. Der von einem spinpolarisierten Elektron bis in den aktiven Bereich zurückzulegende Weg ist damit erheblich kürzer als bei herkömmlichen Anordnungen. Durch einen kurzen Weg zwischen Injektion und Lichterzeugung kann verhindert werden, dass eine Spinpolarisation der Elektronen vor Erreichen des aktiven Bereichs 12 verloren geht. Würde die Spinpolarisation vor Erreichen des aktiven Bereichs 12 verloren gehen, könnte kein polarisiertes Licht mit diesen Elektronen erzeugt werden. Der Weg, den die Elektronen unter Verlust von 50 % der ursprünglichen Spinpolarisation zurücklegen können, wird hier als Spinrelaxationslänge bezeichnet. Vorzugsweise ist der Abstand zwischen den Injektionskontakten 5, 6 und dem aktiven Bereich 12 kleiner als die Spinrelaxationslänge. Die Spinrelaxationslänge kann insbesondere von einer Temperatur und/oder einer magnetischen Feldstärke abhängen. Durch den kleinen Abstand zwischen den Injektionskontakten 5, 6 und dem aktiven Bereich 12 kann die Temperatur, bei welcher der Laser betrieben wird, vergleichsweise hoch gewählt werden, weil eine vergleichsweise kleine Spinrelaxationslänge ausreichend ist, um das Elektron unter Erhaltung der Spinpolarisation in das aktive Gebiet zu bringen. Somit ist es möglich, den beschriebenen Laser 1 auch bei Temperaturen und magnetischen Feldstärken einzusetzen, die deutlich einfacher zu erhalten sind als beispielsweise wenige 10 mK bei mehreren Tesla. So kann der Laser 1 beispielsweise bei Raumtemperatur und ohne externes Magnetfeld eingesetzt werden.

Der Laser 1 kann insbesondere mit einem Verfahren betrieben werden, bei dem spinpolarisierte Elektronen über die Injektionskontakte 5, 6 in den aktiven Bereich 12 des Lasers 1 injiziert werden und bei dem die Polarisation des von dem Laser 1 erzeugten Laserlichts mittels der Spinpolarisation der Elektronen gesteuert wird. Das so erzeugte Laserlicht kann insbesondere zur Übermittlung von Informationen verwendet werden. Die Informationen können dabei durch die Polarisation der Elektronen und folglich durch die Polarisation des von dem Laser 1 erzeugten Lichts kodiert sein.

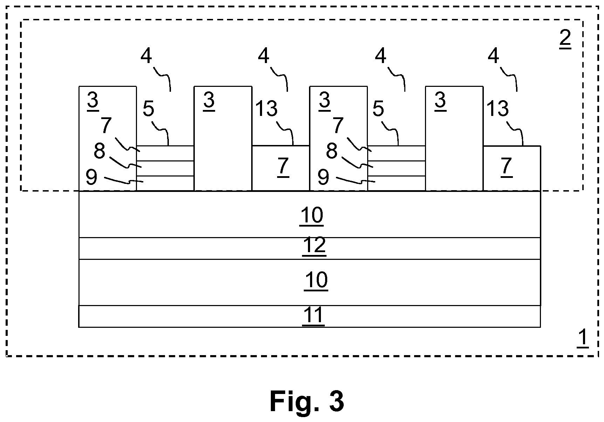

Eine bestimmte Polarisation des erzeugten Lichts kann durch eine bestimmte Spinpolarisation der injizierten Elektronen erhalten werden. Die in Fig. 1 gezeigte Ausführungsform umfasst verschieden ausgebildete Injektionskontakte 5, 6. Erste Injektionskontakte 5 können dabei eine erste Magnetfeldrichtung aufweisen und damit Spin-Up-Elektronen erzeugen und injizieren. Zweite Injektionskontakte 6 weisen dann eine Magnetfeldrichtung auf, die entgegengesetzt zur Magnetfeldausrichtung der ersten Injektionskontakte ist, sodass Spin-Down-Elektronen erzeugt und injiziert werden können. Dadurch lässt sich das gesamte Ladungsträgersystem, also die Elektronen, zwischen Up- und Down-Spin umschalten. Dies resultiert in rechts- bzw. linkszirkularer Lichtemission. Alternativ können, wie im Beispiel der Fig. 3 gezeigt, Injektionskontakte 5 oder 6 und Metallkontakte 13 verwendet werden. Dabei werden durch die Injektionskontakte 5 oder 6 entweder Spin-Up- oder Spin-Down-Elektronen injiziert, die die jeweilige Spin-Polarisation im Ladungsträgersystem bewirken. Durch die Metallkontakte 13 können gleich viele Spin-Up- und Spin-Down-Elektronen injiziert werden, wodurch sich die Spin-Polarisation im Ladungsträgersystem abbaut. Weiterhin können auch beispielswiese mehr als zwei verschiedene Kontakttypen verwendet werden. Das für die erste Ausführungsform und für die zweite Ausführungsform Gesagte kann auf derartige Ausführungsformen übertragen werden.

Um die Spinpolarisation der Elektronen verändern zu können, sind in der in Fig. 1 gezeigten Ausführungsform erste Injektionskontakte 5 und zweite Injektionskontakte 6 in wechselweiser Anordnung angeordnet. Die ersten Injektionskontakte 5 sind dabei zur Injektion von Elektronen mit einer ersten Spinpolarisation und die zweiten Injektionskontakte 6 zur Injektion von Elektronen mit einer von der ersten Spinpolarisation verschiedenen, zweiten Spinpolarisation ausgebildet. Insbesondere können alle ersten Injektionskontakte 5 gemeinsam an eine erste Stromzuleitung angebunden sein und alle zweiten Injektionskontakte 6 an eine zweite Stromzuleitung. Die Anzahl der durch die Injektionskontakte 5, 6 injizierten Elektronen kann durch eine auf die jeweilige Stromzuleitung aufgeprägte Stromstärke eingestellt werden. Wird nur Strom auf die erste Zuleitung gegeben, dann werden nur Elektronen mit der ersten Spinpolarisation injiziert, so dass Licht mit einer ersten Polarisation erzeugt wird. Wird nur Strom auf die zweite Zuleitung gegeben, werden nur Elektronen mit der zweiten Spinpolarisation injiziert, so dass Licht mit einer zweiten Polarisation erzeugt wird. Wird Strom mit einer ersten Stromstärke auf die erste Zuleitung und mit einer zweiten Stromstärke auf die zweite Zuleitung gegeben, kann die erhaltene Polarisation durch das Verhältnis der Arbeitspunkte der beiden Kontakte eingestellt werden. Die wechselweise Anordnung der ersten Injektionskontakte 5 und der zweiten Injektionskontakte 6 bedeutet, dass zumindest in einer Richtung auf einen ersten Injektionskontakt 5 ein zweiter Injektionskontakt 6 folgt. Vorzugsweise folgt in jeder Richtung auf einen ersten Injektionskontakt 5 ein zweiter Injektionskontakt 6. Das ist der Fall in dem in Fig. 2 gezeigten Beispiel. Eine solche wechselweise Anordnung ermöglicht, dass Elektronen verschiedener Polarisation gleichverteilt in den aktiven Bereich 12 injiziert werden können.

Die ersten Injektionskontakte 5 und die zweiten Injektionskontakte 6 sind vorzugsweise derart voneinander verschieden ausgebildet, dass die Magnetisierungen entgegengesetzt zueinander ausgerichtet sind und dadurch die erste Spinpolarisation der zweiten Spinpolarisation entgegengesetzt ist. Das kann insbesondere durch eine entgegengesetzte Magnetisierung der ferromagnetischen Schichten 8 der Injektionskontakte 5, 6 erreicht werden.

Für die Erzeugung der ersten Injektionskontakte 5 und der zweiten Injektionskontakte 6 werden vorzugsweise die ferromagnetischen Schichten 8 derart geschaffen, dass diese eine out-of-plane-Magnetisierung aufweisen. Das kann beispielsweise durch eine Multilayer-Struktur erreicht werden. Nach dem Wachsen der ferromagnetischen Schichten 8 erfolgt vorzugsweise eine Orientierung von magnetischen Domänen innerhalb der ferromagnetischen Schichten 8 durch ein externes Magnetfeld, das zu diesem Schritt des Herstellungsprozesses des Lasers 1 angelegt wird. Die magnetischen Domänen in den ferromagnetischen Schichten 8 bleiben nach dem Ausschalten des externen Magnetfeldes in der entsprechenden Richtung ausgerichtet. Je nach Richtung des externen Magnetfeldes kann die Magnetisierung der ferromagnetischen Schichten 8 eingestellt werden. Dabei kann ausgenutzt werden, dass die Magnetisierungskennlinie eine Hysteresekurve ist. Aus der Hysteresekurve ergibt sich, dass eine Ummagnetisierung der entsprechenden ferromagnetischen Schicht 8 ein Mindest-Magnetfeld - die Koerzitivfeldstärke - erfordert.

Damit die ersten Injektionskontakte 5 und die zweiten Injektionskontakte 6 ferromagnetische Schichten 8 mit entgegengesetzter Magnetisierung aufweisen können, weisen die ferromagnetischen Schichten 8 bei den beiden Typen von Injektionskontakten 5, 6 vorzugsweise verschiedene Koerzitivfeldstärken auf, so dass die Hysteresekurven vorzugsweise unterschiedlich breit ausgebildet sind. Durch Anlegen beispielsweise eines externen positiven und anschließend eines negativen Feldes können den beiden Typen von Injektionskontakten 5, 6 verschieden ausgerichtete Magnetisierungen oder Magnetisierungsrichtungen aufgeprägt werden. So kann zunächst ein höheres magnetisches Feld in eine erste Richtung angelegt werden, so dass die ferromagnetischen Schichten 8 beider Typen von Injektionskontakten 5, 6 in die erste Richtung magnetisiert werden. Anschließend kann ein schwächeres, in eine der ersten Richtung entgegengesetzten zweiten Richtung ausgerichtetes magnetisches Feld angelegt werden, das nur die ferromagnetischen Schichten 8 der Injektionskontakte 5 oder 6 mit der schmaleren Hysteresekurve ummagnetisiert, während die ferromagnetischen Schichten 8 der übrigen Injektionskontakte 5 oder 6 unverändert bleiben.

Die Breite der Hysteresekurve ist beispielswiese abhängig von der räumlichen Ausdehnung der ferromagnetischen Schicht 8, so dass durch unterschiedliche Dimensionierungen der Injektionskontakte 5, 6 verschiedene Hysteresekurven erhalten werden können. Die Ausführungsform in Fig. 1 zeigt, dass die ferromagnetisehe Schicht 8 bei den ersten Injektionskontakten 5 dünner ist als bei den zweiten Injektionskontakten 6, während die Tunnelbarriere 9 bei den ersten Injektionskontakten 5 dicker ist als bei den zweiten Injektionskontakten 6. Durch unterschiedliche Schichtdicken der ferromagnetischen Schicht 8 kann eine unterschiedliche Koerzitivfeldstärke erhalten werden, so dass die ferromagnetischen Schichten 8 der verschiedenen Injektionskontakte 5, 6 entgegengesetzt magnetisiert werden können.

Alternativ oder zusätzlich können verschiedene Materialkombinationen verschiedene Hysteresekurven aufweisen, sodass die beiden Typen von Injektionskontakten 5, 6 durch verschiedene Materialien bewirkt werden können.

Eine alternative Möglichkeit für die unterschiedliche Magnetisierung beider Typen von Injektionskontakten bei gleichem Material und gleichen Dimensionen ist eine optomagnetische Vorgehensweise. Dabei werden beide Typen von Injektionskontakten zunächst gleich magnetisiert. Anschließend wird ein entgegengesetztes Magnetfeld mit einer betragsmäßig schwächeren Feldstärke so angelegt, dass die Hysterese nicht durchlaufen wird, sondern das Material nur kurz vor der Ummagnetisierung steht. Nun können mit Hilfe eines fokussierten Lasers die Kontaktbereiche nur einer Kontaktart abgerastert werden, sodass sich das Material in genau diesen Bereichen kurz erhitzt, während die Bereiche der anderen Kontaktart nicht erhitzt werden. Durch die Erhitzung verschiebt sich die Hysteresekurve des Materials derart, dass das bereits angelegte externe Magnetfeld für eine Ummagnetisierung ausreicht, so dass auf diese Weise die Magnetisierung der erhitzten Kontakte ausgerichtet wird und diese anschließend eine zur ersten Magnetisierungsrichtung entgegengesetzte Magnetisierung aufweisen. Eine durch die optomagnetische Vorgehensweise erhaltene Vorrichtung kann insbesondere Injektionskontakte 5, 6 aufweisen, die mit Ausnahme der unterschiedlichen Magnetisierungen identisch zueinander ausgebildet sind.

Fig. 3 zeigt eine schematische Querschnittsdarstellung eines zweiten Ausführungsbeispiels eines Lasers 1 mit einer Vorrichtung 2 zur Injektion spinpolarisierter Elektronen und zur Reflexion von Licht. Die zweite Ausfuhrungsform ist bis auf die im Folgenden beschriebenen Unterschiede zur ersten Ausführungsform identisch.

Bei der zweiten Ausführungsform sind nur erste Injektionskontakte 5 und zudem Metallkontakte 13 in den Ausnehmungen 4 angeordnet, sodass nicht in allen Ausnehmungen 4 der Gitterstruktur 3 Injektionskontakte 5, 6 angeordnet sind. Die Metallkontakte 13 dienen der Injektion von Elektronen ohne Spinpolarisation. In dieser Ausführungsform können also über die ersten Injektionskontakte 5 Elektronen mit einer ersten Spinpolarisation und über die Metallkontakte 13 Elektronen ohne Spinpolarisation injiziert werden. Im Gegensatz dazu können bei der ersten Ausführungsform über die ersten Injektionskontakte 5 Elektronen mit der ersten Spinpolarisation und über die zweiten Injektionskontakte 6 Elektronen mit der zweiten Spinpolarisation injiziert werden. Eine Spinpolarisation von null kann in einer Ausführungsform mit einfachen Metallkontakten 13 erzielt werden, die keine Magnetisierung aufweisen. Eine Tunnelbarriere 9 ist bei den Metallkontakten 13 nicht erforderlich.

Die Herstellung der zweiten Ausführungsform ist gegenüber der ersten Ausführungsform vereinfacht, weil nur Injektionskontakte 5 eines Typs magnetisiert werden müssen, während die Metallkontakte 13 keine Nachbehandlung benötigen.

Bei dem beschriebenen Verfahren zum Betrieb der Anordnung, insbesondere des Lasers, ist es bevorzugt, dass die Resonanzfrequenz der Anordnung, die ein Polarisationsmodulationssystem bildet, mit Hilfe der Doppelbrechung beeinflusst und insbesondere maximiert wird. Ferner ist es bevorzugt, dass die beeinflusste und insbesondere maximierte Resonanzfrequenz des Polarisationsmodulationssystems beispielsweise für optische Datenübertragung verwendet wird.

### Bezugszeichenliste

1 Anordnung
2 Vorrichtung
3 Gitterstruktur
4 Ausnehmung
5 erster Injektionskontakt
6 zweiter Injektionskontakt
7 metallische Schicht
8 ferromagnetische Schicht
9 Tunnelbarriere
10 Ausgleichsschicht
11 Spiegel
12 aktiver Bereich
13 Metallkontakt
14 Ausdehnung

## Patentansprüche

1. Vorrichtung (2), die für die Injektion spinpolarisierter Elektronen und für die Reflexion von Licht in einen Laser oder in eine resonante LED bestimmt und eingerichtet ist,
wobei die Vorrichtung zumindest eine Gitterstruktur (3) mit einer Vielzahl von Ausnehmungen (4), wobei die Gitterstruktur (3) zur Reflexion des Lichts ausgebildet ist, umfasst,
**dadurch gekennzeichnet, dass**
in zumindest einem Teil der Ausnehmungen (4) ein jeweiliger Injektionskontakt (5, 6), der eine jeweilige ferromagnetische Schicht (8) umfasst, zur Injektion von spinpolarisierten Ladungsträgern angeordnet ist.

2. Vorrichtung (2) nach Anspruch 1, wobei erste Injektionskontakte (5) und zweite Injektionskontakte (6) in wechselweiser Anordnung angeordnet sind, und wobei die ersten Injektionskontakte (5) zur Injektion von Elektronen mit einer ersten Spinpolarisation und die zweiten Injektionskontakte (6) zur Injektion von Elektronen mit einer von der ersten Spinpolarisation verschiedenen zweiten Spinpolarisation ausgebildet sind.

3. Vorrichtung (2) nach einem der vorstehenden Ansprüche, wobei weiterhin in einem Teil der Ausnehmungen (4) Metallkontakte (13) zur Injektion von Elektronen ohne Spinpolarisation vorgesehen sind.

4. Vorrichtung (2) nach einem der vorstehenden Ansprüche, wobei die Länge der Ausnehmungen (4) in der Gitterstruktur (3) kleiner als die Wellenlänge des zu reflektierenden Lichts ist.

5. Vorrichtung (2) nach einem der vorstehenden Ansprüche, wobei zumindest ein Teil der Injektionskontakte (5, 6) eine jeweilige ferromagnetische Schicht (8) umfasst.

6. Vorrichtung (2) nach Anspruch 5, wobei die ferromagnetische Schicht (8) eine Magnetisierung aufweist, die senkrecht zu der ferromagnetischen Schicht (8) orientiert ist.

7. Vorrichtung (2) nach einem der vorstehenden Ansprüche, wobei zumindest ein Teil der Injektionskontakte (5, 6) eine jeweilige Tunnelbarriere (9) umfasst.

8. Anordnung (1) umfassend einen aktiven Bereich (12), einen Spiegel (11) und eine Vorrichtung (2) gemäß einem der vorstehenden Ansprüche, wobei der Spiegel (11) und die Vorrichtung (2) zur Reflexion von Licht auf entgegengesetzten Seiten des aktiven Bereichs (12) angeordnet sind.

9. Anordnung (1) nach Anspruch 8, wobei zumindest ein Teil der Injektionskontakte (5, 6) der Vorrichtung (2) als ein jeweiliger Schottky-Kontakt ausgebildet ist.

10. Verfahren zum Betrieb einer Anordnung (1) nach Anspruch 9, wobei spinpolarisierte Elektronen über die Injektionskontakte (5, 6) in den aktiven Bereich (12) der Anordnung (1) injiziert werden, und wobei eine Polarisation des von der Anordnung (1) erzeugten Lichts mittels der Spinpolarisation der Elektronen beeinflusst wird.

## Claims

1. Device (2) which is intended and designed for the injection of spin-polarized electrons and for the reflection of light into a laser or into a resonant LED, the device comprising at least one lattice structure (3) with a large number of recesses (4), the lattice structure (3) being designed to reflect light, **characterized in that** a respective injection contact (5, 6), which comprises a respective ferromagnetic layer (8), is arranged in at least some of the recesses (4) in order to inject spin-polarized charge carriers.

2. Device (2) according to claim 1, wherein first injection contacts (5) and second injection contacts (6) are arranged in an alternating arrangement, and wherein the first injection contacts (5) are designed to inject electrons having a first spin polarization and the second injection contacts (6) are designed to inject electrons having a second spin polarization different from the first spin polarization.

3. Device (2) according to any of the preceding claims, wherein metal contacts (13) are further provided in some of the recesses (4) in order to inject electrons without spin polarization.

4. Device (2) according to any of the preceding claims, wherein the length of the recesses (4) in the lattice structure (3) is smaller than the wavelength of the light to be reflected.

5. Device (2) according to any of the preceding claims, wherein at least some of the injection contacts (5, 6) comprise a respective ferromagnetic layer (8).

6. Device (2) according to claim 5, wherein the ferromagnetic layer (8) has a magnetization which is oriented perpendicularly to the ferromagnetic layer (8).

7. Device (2) according to any of the preceding claims, wherein at least some of the injection contacts (5, 6) comprise a respective tunnel barrier (9).

8. Arrangement (1) comprising an active region (12), a mirror (11) and a device (2) according to any of the preceding claims, wherein the mirror (11) and the device (2) are arranged to reflect light on opposite sides of the active region (12).

9. Arrangement (1) according to claim 8, wherein at least some of the injection contacts (5, 6) of the device (2) are designed as a respective Schottky contact.

10. Method for operating an arrangement (1) according to claim 9, wherein spin-polarized electrons are injected via the injection contacts (5, 6) into the active region (12) of the arrangement (1), and wherein a polarization of the light generated by the arrangement (1) is influenced by the spin polarization of the electrons.

## Revendications

1. Dispositif (2) destiné à et configuré pour l'injection d'électrons polarisés en spin et pour la réflexion de lumière dans un laser ou dans une DEL résonnante,
dans lequel le dispositif comprend au moins une structure en treillis (3) comportant une pluralité d'évidements (4), la structure en treillis (3) étant conçue pour la réflexion de la lumière,
**caractérisé en ce que**
dans au moins une partie des évidements (4), un contact d'injection (5, 6) respectif est disposé pour l'injection de porteurs de charge polarisés en spin, lequel contact d'injection comprend une couche ferromagnétique (8) respective.

2. Dispositif (2) selon la revendication 1, dans lequel des premiers contacts d'injection (5) et des seconds contacts d'injection (6) sont disposés en alternance, et dans lequel les premiers contacts d'injection (5) sont conçus pour l'injection d'électrons avec une première polarisation en spin et les seconds contacts d'injection (6) sont conçus pour l'injection d'électrons avec une seconde polarisation en spin différente de la première polarisation en spin.

3. Dispositif (2) selon l'une des revendications précédentes, dans lequel des contacts métalliques (13) pour l'injection d'électrons sans polarisation en spin sont en outre prévus dans une partie des évidements (4).

4. Dispositif (2) selon l'une des revendications précédentes, dans lequel la longueur des évidements (4) dans la structure en treillis (3) est inférieure à la longueur d'onde de la lumière qui doit être réfléchie.

5. Dispositif (2) selon l'une des revendications précédentes, dans lequel au moins une partie des contacts d'injection (5, 6) comprennent une couche ferromagnétique (8) respective.

6. Dispositif (2) selon la revendication 5, dans lequel la couche ferromagnétique (8) présente une magnétisation orientée perpendiculairement à la couche ferromagnétique (8).

7. Dispositif (2) selon l'une des revendications précédentes, dans lequel au moins une partie des contacts d'injection (5, 6) comprennent une barrière à effet tunnel (9) respective.

8. Agencement (1) comprenant une région active (12), un miroir (11) et un dispositif (2) selon l'une des revendications précédentes, dans lequel le miroir (11) et le dispositif (2) sont disposés sur des faces opposées de la région active (12) pour la réflexion de lumière.

9. Agencement (1) selon la revendication 8, dans lequel au moins une partie des contacts d'injection (5, 6) du dispositif (2) sont conçus sous la forme d'un contact Schottky respectif.

10. Procédé permettant de faire fonctionner un agencement (1) selon la revendication 9, dans lequel des électrons polarisés en spin sont injectés dans la région active (12) de l'agencement (1) par l'intermédiaire des contacts d'injection (5, 6), et dans lequel une polarisation de la lumière générée par l'agencement (1) est influencée par la polarisation en spin des électrons.
